# EUROPÄISCHE PATENTANMELDUNG

(11) **EP 1 906 717 A2**
(43) Veröffentlichungstag der Anmeldung: **02.04.2008**
(21) Anmeldenummer: 07017355.4
(22) Anmeldetag: 05.09.2007
(51) Int. Cl.: H05K 3/32

(54) **Bauteilanordnung**

(30) Priorität: 28.09.2006 DE 102006046260
(71) Anmelder: Diehl AKO Stiftung & Co. KG, 88239 Wangen (DE)
(72) Erfinder: Potthof, Erwin, 90552 Röthenbach (DE); Wolf, Johann, 90768 Fürth (DE)
(74) Vertreter: Diehl Patentabteilung

(57) **Zusammenfassung**

Es wird eine Bauteilanordnung mit einem elektronischen Bauteil (10) mit wenigstens einem elektrischen Anschlusspin (16); einer Leiterplatte (12) mit wenigstens einer elektrischen Kontaktfläche (14), mit welcher der Anschlusspin (16) des Bauteils (10) in elektrisch leitendem Kontakt steht; und einer Befestigungsvorrichtung zum Sichern des elektrisch leitenden Kontakts zwischen dem Anschlusspin (16) und der Kontaktfläche (14) vorgesehen, bei welchem der Anschlusspin (16) in seinem Endbereich (18) im Wesentlichen parallel zur Leiterplatte (12) verlaufend ausgebildet ist; die Kontaktfläche (14) im Randbereich der Leiterplatte (12) angeordnet ist; und die Befestigungsvorrichtung eine auf den Rand der Leiterplatte (12) aufschiebbare Klemme (20) aufweist, die einen ersten Abschnitt (22) auf der der Kontaktfläche (14) abgewandten Seite der Leiterplatte (12) und einen zweiten Abschnitt (24) auf der der Kontaktfläche (14) zugewandten Seite der Leiterplatte aufweist, welche die Leiterplatte (12), die Kontaktfläche (14) und den Endbereich (18) des Anschlusspins (16) so zwischen sich aufnehmen, dass der Endbereich (18) des Anschlusspins (16) gegen die Kontaktfläche (14) der Leiterplatte (12) gedrückt wird. Eine bevorzugte Anwendung wird zum Beispiel in der lötfreien Verbindung eines Displays mit einer Leiterplatte bei einer Herdschaltuhr gesehen.

## Beschreibung

Die vorliegende Erfindung betrifft eine Bauteilanordnung gemäß dem Oberbegriff des Anspruchs 1, und insbesondere eine solche Bauteilverbindung, die eine lötfreie Verbindung eines Bauteils mit einer Leiterplatte ermöglicht.

Bei herkömmlichen Bauteilanordnungen besteht zum Beispiel bei Steuerungen für Hausgeräte das Problem, dass die Leiterplattenseite, auf welcher das Display zu bestücken ist, gleichzeitig die Lötseite ist. Deshalb sind entweder spezielle Einrichtungen erforderlich, um eine maschinelle Lötverbindung des Displays herzustellen, oder das Display wird manuell mit der Leiterplatte verlötet. Beide Montagevarianten sind relativ aufwändig. Im Fall der Maschinen- oder Roboterlösung sind bei der Entwicklung der Leiterplatte zudem die Gestaltungsfreiheit der Leiterplatte einschränkende Vorgaben einzuhalten, welche die nutzbare Bestückungsfläche der Leiterplatte verringern.

Die vorliegende Erfindung hat deshalb die Aufgabe, eine Bauteilanordnung vorzusehen, die sowohl eine einfache Montage des Bauteils auf der Leiterplatte als auch eine sichere elektrische Kontaktierung zwischen diesen beiden Komponenten im Betrieb der Bauteilanordnung gewährleistet.

Diese Aufgabe wird gelöst durch eine Bauteilanordnung mit den Merkmalen des Anspruchs 1. Vorteilhafte Ausgestaltungen und Weiterbildungen der Erfindung sind Gegenstand der abhängigen Ansprüche.

Die erfindungsgemäße Bauteilanordnung enthält ein elektronisches Bauteil mit wenigstens einem elektrischen Anschlusspin; eine Leiterplatte mit wenigstens einer elektrischen Kontaktfläche, mit welcher der Anschlusspin des Bauteils in elektrisch leitendem Kontakt steht; und eine Befestigungsvorrichtung zum Sichern des elektrisch leitenden Kontakts zwischen dem Anschlusspin und der Kontaktfläche. Weiter ist der Anschlusspin in seinem Endbereich im Wesentlichen parallel zur Leiterplatte verlaufend ausgebildet; die Kontaktfläche ist im Randbereich der Leiterplatte angeordnet; und die Befestigungsvorrichtung weist eine auf den Rand der Leiterplatte aufschiebbare Klemme auf, die einen ersten Abschnitt auf der der Kontaktfläche abgewandten Seite der Leiterplatte und einen zweiten Abschnitt auf der der Kontaktfläche zugewandten Seite der Leiterplatte aufweist, welche die Leiterplatte, die Kontaktfläche und den Endbereich des Anschlusspins so zwischen sich aufnehmen, dass der Endbereich des Anschlusspins gegen die Kontaktfläche der Leiterplatte gedrückt wird.

Da der Anschlusspin in seinem Endbereich im Wesentlichen parallel zur Leiterplatte verlaufend ausgebildet ist; die Kontaktfläche im Randbereich der Leiterplatte angeordnet ist; und die Befestigungsvorrichtung eine auf den Rand der Leiterplatte aufschiebbare Klemme aufweist, die die Leiterplatte, die Kontaktfläche und den Endbereich des Anschlusspins so zwischen sich aufnimmt, dass der Endbereich des Anschlusspins gegen die Kontaktfläche der Leiterplatte gedrückt wird, ist eine lötfreie Verbindung des Bauteils mit der Leiterplatte durch einen dauerhaften Druckkontakt, der von der Klemme bewirkt wird, ermöglicht. Hierdurch werden die oben genannten Nachteile im Stand der Technik, die ihre Ursache in der Lötverbindung haben, beseitigt und es wird eine einfache Montage des Bauteils auf der Leiterplatte bei gleichzeitig sicherer elektrischer Kontaktierung erreicht. Es entsteht zudem ein logistischer Vorteil, da die Leiterplattenbaugruppe vorgefertigt und das vom Kunden geforderte Bauteil in der Endmontage eingesetzt werden kann, sodass Varianten am Ende der Wertschöpfungskette problemlos gebildet werden können.

Die Befestigungsvorrichtung sollte elektrisch isolierend ausgebildet sein, um elektrische Kurzschlüsse zwischen benachbarten Kontaktflächen sicher zu vermeiden. Dies kann zum Beispiel erreicht werden, indem die Klemme elektrisch isolierend ausgebildet wird oder zwischen der Klemme und den Komponenten Leiterplatte, Kontaktfläche und Anschlusspin eine Isolierfolie angeordnet wird.

In einer Ausgestaltung der Erfindung ist die Klemme aus einem federelastischen Material gefertigt, zum Beispiel einem Stahlblech, das gut formbar ist, federnde Eigenschaften besitzt und ausreichend warmfest ist.

In einer Ausführungsform der Erfindung weist die Klemme am Ende ihres zweiten Abschnitts eine nach innen und zurück gebogene Kante auf, die den Endbereich des Anschlusspins gegen die Kontaktfläche der Leiterplatte drückt. Bei dieser Form der Klemme kann der Kontaktdruck zwischen dem Anschlusspin und der Kontaktfläche erhöht werden.

In einer weiteren Ausgestaltung der Erfindung ist der zweite Abschnitt der Klemme auf seiner dem Endbereich des Anschlusspins zugewandten Seite mit wenigstens einer Kerbung versehen, sodass der Anschlusspin des Bauteils gegen ein Herausrutschen aus der Klemmverbindung gesichert ist.

In einer noch weiteren Ausgestaltung der Erfindung kann der Endbereich des Anschlusspins auf seiner der Kontaktfläche zugewandten Seite mit mehreren Vorsprüngen versehen sein, um eine punktuelle Kontaktierung mit einem hohen spezifischen Flächendruck zwischen dem Anschlusspin und der Kontaktfläche zu erzielen.

In einer bevorzugten Ausführungsform der Erfindung weist das Bauteil eine Anzahl von Anschlusspins auf; die Leiterplatte weist eine entsprechende Anzahl von Kontaktflächen auf; und die Befestigungsvorrichtung weist eine entsprechende Anzahl von Klemmen auf, die integral miteinander verbunden sind. Durch die integrale Verbindung der Klemmen kann der Montageaufwand stark reduziert werden.

Bei dieser Ausführungsform können die mehreren Klemmen der Befestigungsvorrichtung ferner einen gemeinsamen ersten Abschnitt und eine entsprechende Anzahl von zweiten Abschnitten aufweisen. Auf diese Weise wird jeder Anschlusspin des Bauteils mit einer definierten Kraft gegen die jeweilige Kontaktfläche der Leiterplatte gedrückt.

In einem weiteren bevorzugten Ausführungsbeispiel der Erfindung weist die Befestigungsvorrichtung ferner ein Gehäuse aus einem isolierenden Material auf, in dem die Klemme gehalten ist bzw. die mehreren Klemmen gehalten sind; und das Gehäuse ist in der Art eines Randsteckverbinders auf den Rand der Leiterplatte aufschiebbar. Hierbei enthält das Gehäuse zum Beispiel eine Ausnehmung für die Klemme bzw. mehrere Ausnehmungen für mehrere Klemmen, die Leiterplatte ist mit einer Aussparung zum Aufnehmen einer Wandung des Gehäuses der Befestigungsvorrichtung versehen. Dieses Ausführungsbeispiel vereinfacht die Montage des Bauteils auf der Leiterplatte insbesondere bei Bauteilen mit mehreren Anschlusspins.

In einer weiteren Ausgestaltung der Erfindung weist das Bauteil auf seiner der Leiterplatte zugewandten Seite ferner wenigstens einen Stift auf, dessen Ende in einer Aussparung oder Öffnung in der Leiterplatte geführt ist, sodass eine mechanische Stabilisierung und Positionierung des Bauteils auf der Leiterplatte erreicht wird.

Bei einem bevorzugten Anwendungsfall der Erfindung ist das elektronische Bauteil ein Display und die Bauteilanordnung ist Teil einer Steuerung oder Regelung für Hausgeräte.

Obige sowie weitere Merkmale und Vorteile der Erfindung werden aus der nachfolgenden Beschreibung bevorzugter, nicht-einschränkender Ausführungsbeispiele unter Bezug auf die beiliegenden Zeichnungen besser verständlich. Darin zeigen:
- Fig. 1: eine schematische Seitenansicht des Aufbaus einer Bauteilanordnung gemäß einem ersten Ausführungsbeispiel;
- Fig. 2: eine schematische Seitenansicht des Aufbaus einer Bauteilanordnung gemäß einer Variante des ersten Ausführungsbeispiels;
- Fig.3: eine vergrößerte Perspektivansicht der Befestigungsvorrichtung der Bauteilanordnung von Fig. 1;
- Fig. 4: eine schematische Teilseitenansicht des Aufbaus einer Bauteilanordnung gemäß einer weiteren Variante des ersten Ausführungsbeispiels;
- Fig. 5: eine schematische Draufsicht der Befestigungsvorrichtung gemäß einer noch weiteren Variante des ersten Ausführungsbeispiels;
- Fig. 6: eine schematische Seitenansicht des Aufbaus einer Bauteilanordnung gemäß einem zweiten Ausführungsbeispiel;
- Fig. 7: eine schematische Perspektivansicht der Befestigungsvorrichtung der Bauteilanordnung von Fig. 6; und
- Fig. 8: eine schematische Draufsicht der Bauteilanordnung von Fig. 6.

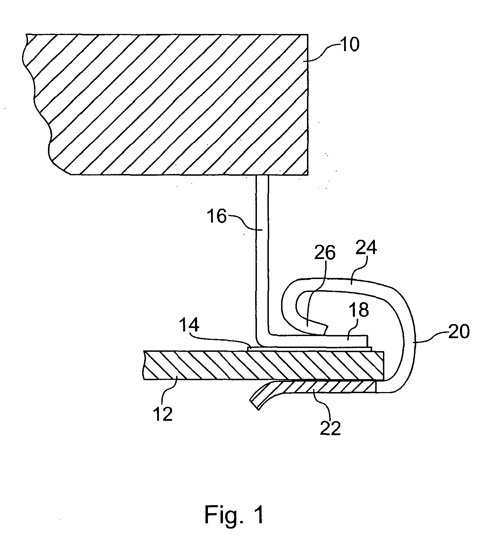

Anhand Fig. 1 bis 5 wird zunächst der Aufbau einer Bauteilanordnung gemäß einem ersten Ausführungsbeispiel und verschiedener Varianten näher erläutert.

Die Bauteilanordnung umfasst im Wesentlichen ein elektronisches Bauteil 10, wie beispielsweise ein Display, eine Leiterplatte 12 und eine Befestigungsvorrichtung 20 zum lötfreien Verbinden des Bauteils 10 mit der Leiterplatte 12. Die Leiterplatte 12 hat mehrere Kontaktflächen 14 zum elektrischen Anschließen des Bauteils 10, die zum Beispiel auf der dem Bauteil 10 zugewandten Oberseite der Leiterplatte 12 in deren Randbereich angeordnet sind. Das elektronische Bauteil 10 besitzt mehrere Anschlusspins 16, die mit den jeweiligen Kontaktflächen 14 der Leiterplatte 12 in elektrisch leitenden Kontakt stehen müssen.

Zur elektrischen Verbindung zwischen den Anschlusspins 16 und den Kontaktflächen 14 sind die Anschlusspins 16 jeweils in ihrem unteren Endbereich 18 so abgewinkelt, dass dieser Endbereich im Wesentlichen parallel zur Leiterplatte 12 und damit zur Kontaktfläche 14 verläuft.

Wie in Fig. 1 veranschaulicht, weist die Befestigungsvorrichtung eine Klemme 20 auf, die einen ersten Abschnitt 22 auf der der Kontaktfläche 14 abgewandten Unterseite der Leiterplatte 12 und einen zweiten Abschnitt 24 auf der der Kontaktfläche 14 zugewandten Oberseite der Leiterplatte 12 besitzt. Am Ende des zweiten Abschnitts 24 ist eine nach innen und zurück gebogene Kante 26 vorgesehen, und am Ende des ersten Abschnitts 22 ist eine etwas nach unten gebogene Kante vorgesehen.

Die Klemme 20 ist auf den Rand der Leiterplatte 12 aufschiebbar und nimmt die Komponenten Leiterplatte 12 und Endbereich 18 des Anschlusspins 16 zwischen ihren beiden Abschnitten 22, 24 auf. Dabei drückt die umgebogene Kante 26 des zweiten Abschnitts 24 der Klemme 20 den Endbereich 18 des Anschlusspins 16 fest gegen die Kontaktfläche 14 der Leiterplatte 12, sodass der Anschlusspin 16 elektrisch leitend mit der Kontaktfläche 14 verbunden ist. Das Aufschieben der Klemme 20 erfolgt zum Beispiel mit einem geeigneten Montagewerkzeug, das so ausgelegt ist, dass die Anschlusspins 16 des Bauteils 10 gegen die schiebende Krafteinwirkung der Klemme 20 abgestützt werden.

Die Klemme 20 der Befestigungsvorrichtung muss so ausgebildet sein, dass sie den erforderlichen Kontaktdruck zwischen Anschlusspin 16, 18 und Kontaktfläche 14 auch bei den erwarteten Umgebungstemperaturen (z.B. bis etwa 120°C für Herdschaltuhren) aufrecht hält. Materialien, die bei Temperatur ermüden bzw. zu fließen beginnen, scheiden somit für die Klemme 20 aus. Außerdem muss das Material der Klemme 20 gut formbar sein, aber auch federelastische Eigenschaften besitzen, was durch die Auswahl einer geeigneten Federhärte geschehen kann. Ein bevorzugtes Material für die Klemme 20 ist daher zum Beispiel Stahlblech, das nach der Formgebung der Klemme 20 gehärtet oder einsatzgehärtet wird. Eine solche Härtung erzeugt zugleich eine Oxidschicht auf der Oberfläche, wodurch die Klemmenoberfläche elektrisch nichtleitend gemacht wird. Die elektrisch nichtleitende Eigenschaft der Klemme 20 ist von Vorteil, um Kürzschlüsse zwischen benachbarten Kontaktflächen 14 bzw. Anschlusspins 16 sicher zu vermeiden.

Die oben beschriebene Bauteilanordnung zeichnet sich durch eine einfache und damit kostengünstige Montage sowie eine sichere elektrische Kontaktierung bei den jeweiligen Betriebsbedingungen aus. Die elektrische Verbindung des Bauteils 10 mit der Leiterplatte 12 wird lötfrei durch eine dauerhafte Pressung der jeweiligen Kontaktelemente 14 und 18 erreicht.

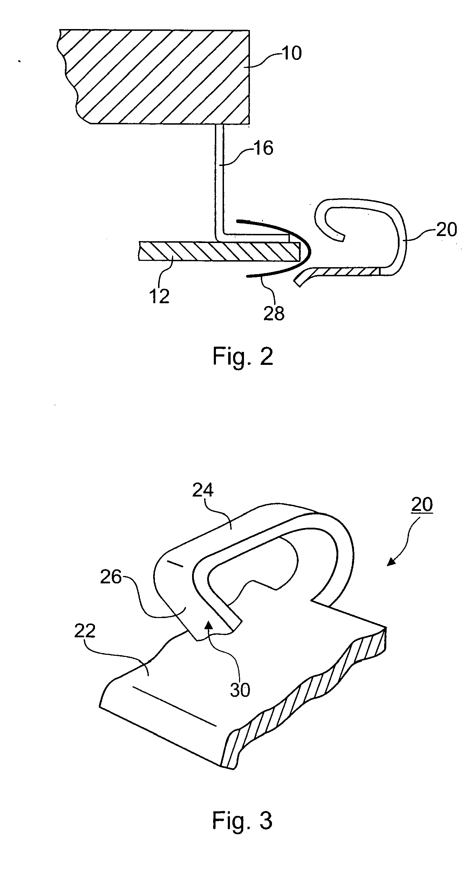

Um die elektrisch nichtleitende Eigenschaft der Klemme 20 zu erzielen, kann die metallische Klemme 20 auch (zumindest partiell) mit einem elektrisch nichtleitenden Material beschichtet, z.B. emailliert werden. In einer weiteren Variante, wie sie in Fig. 2 schematisch dargestellt ist, kann alternativ oder zusätzlich auch eine Isolierfolie 28 vorgesehen werden, die zusammen mit der metallischen Klemme 20 in einem Arbeitsgang auf die Leiterplatte 12 aufgeschoben wird.

Wie in Fig. 3 dargestellt, kann ferner der zweite Abschnitt 24 bzw. die Kante 26 der Klemme 20 auf seiner/ihrer dem Endbereich 18 des Anschlusspins 16 zugewandten Seite mit wenigstens einer (z.B. eingeprägten) Kerbung 30 versehen sein. Diese Kerbung 30 sichert den Anschlusspin 16 gegen ein Herausrutschen aus der Klemmverbindung.

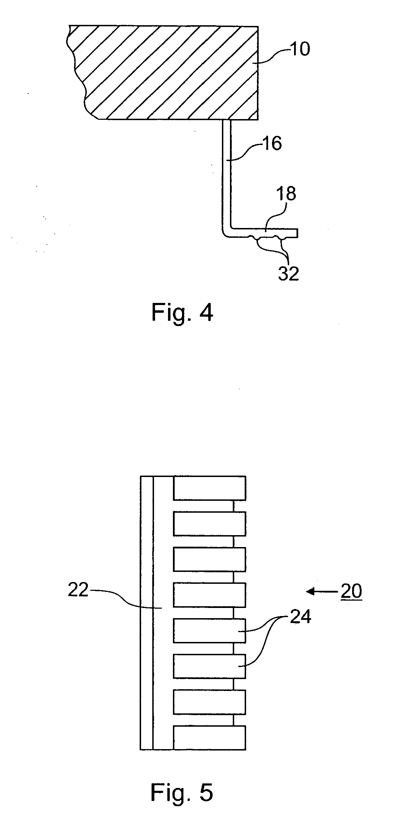

In einer in Fig. 4 angedeuteten weiteren Variante werden im Endbereich 18 des Anschlusspins 16 zusätzlich Kerben eingeschlagen, die zu Materialaufwerfungen bzw. Vorsprüngen 32 führen. Diese Vorsprünge 32 bewirken wiederum eine punktuelle Kontaktierung zwischen Anschlusspin 16 und Kontaktfläche 14 mit einem entsprechend hohen spezifischen Flächendruck. Auf diese Weise wird eine sichere elektrische Kontaktierung zwischen Anschlusspin 16 und Kontaktfläche 14 gewährleistet.

Sofern das Bauteil 10, wie zum Beispiel das oben genannte Display für eine Herdschaltuhr, eine Anzahl von Anschlusspins 16 besitzt, denen eine entsprechende Anzahl von Kontaktflächen 14 auf der Leiterplatte 12 gegenüber liegt, können die in entsprechender Anzahl vorgesehenen Klemmen 20 vorzugsweise integral ausgebildet sein. Wie in Fig. 5 veranschaulicht, weisen die mehreren Klemmen 20 der Befestigungsvorrichtung zum Beispiel einen gemeinsamen ersten Abschnitt 22 und eine entsprechende Anzahl von individuellen zweiten Abschnitten 24 auf. Bei dieser Ausgestaltung ist die Montage deutlich vereinfacht, und dennoch wird der Endbereich 18 jedes Anschlusspins 16 mit einer definierten Kraft gegen die jeweilige Kontaktfläche 14 der Leiterplatte 12 gedrückt, sodass Toleranzen oder Unebenheiten ausgeglichen werden können.

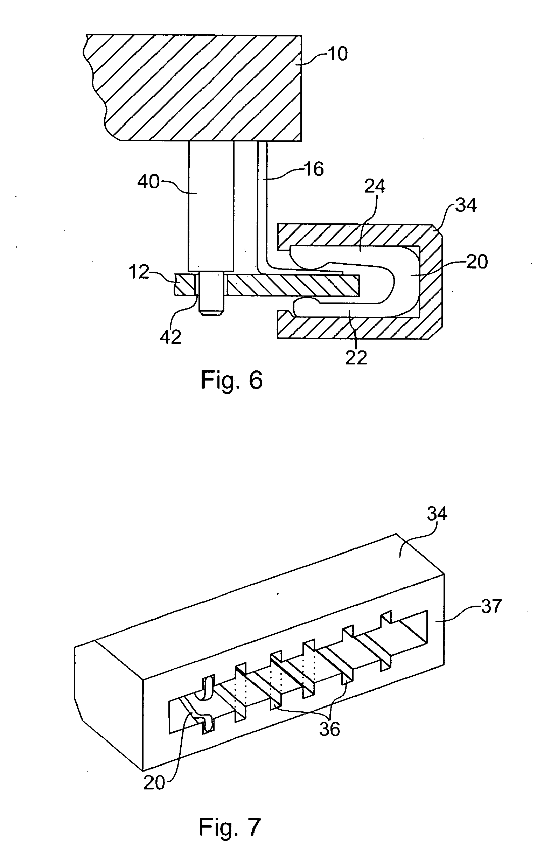

Unter Bezug auf Fig. 6 bis 8 wird nachfolgend ein zweites Ausführungsbeispiel einer Bauteilanordnung der Erfindung näher erläutert.

In diesem Ausführungsbeispiel wird die Befestigungsvorrichtung in der Art eines Randsteckverbinders auf den Rand der Leiterplatte 12 aufgeschoben. Zu diesem Zweck weist die Befestigungsvorrichtung ein Gehäuse 34 auf, in dem entsprechende Ausnehmungen 36 für die Klemmen 20 ausgebildet sind.

Die Klemmen 20 können grundsätzlich wie die Klemmen 20 der obigen Beispiele ausgebildet sein. Wie in Fig. 6 dargestellt, besitzen die Klemmen 20 aber keine umgebogene Kante 26 am Ende des zweiten Abschnitts 24, sondern jeweils einen Wulst oder dergleichen im Endbereich des zweiten Abschnitts 24, deren mit einem hohen spezifischen Flächendruck den Endbereich 18 des Anschlusspins 16 gegen die Kontaktfläche 14 der Leiterplatte 12 presst.

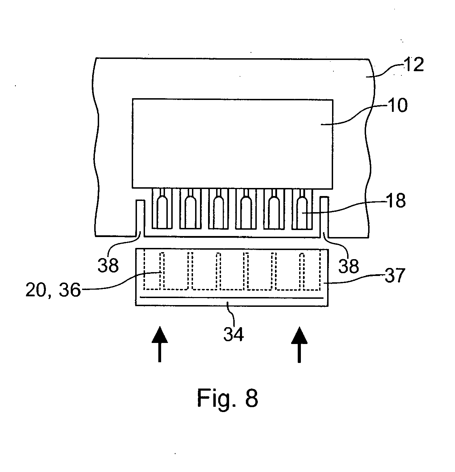

Die Befestigungsvorrichtung, deren Gehäuse 34 besonders gut in Fig. 7 erkennbar ist, wird wie ein dem Fachmann bekannter Leiterplatten-Randsteckverbinder auf die Leiterplatte 12 aufgeschoben. Wie in Fig. 8 veranschaulicht, weist die Leiterplatte 12 zu diesem Zweck Aussparungen 38 in ihrem Rand auf, in die die entsprechenden Wandungen 37 des Klemmengehäuses 34 eingefügt werden können.

Wieder Bezug nehmend auf Fig. 6, weist das Bauteil 10 ferner auf seiner der Leiterplatte 12 zugewandten Seite wenigstens einen Stift 40 auf. Das Ende dieses Stifts 40 ist in einer entsprechenden Aussparung oder Öffnung 42 in der Leiterplatte 12 geführt. Auf diese Weise kann das Bauteil 10 auch mechanisch in der gewünschten Position gehalten und positioniert werden. Diese Ausgestaltung ist in gleicher Weise auch bei den oben beschriebenen Beispielen verwendbar.

### BEZUGSZIFFERNLISTE

- 10: elektronisches Bauteil
- 12: Leiterplatte
- 14: Kontaktfläche
- 16: Anschlusspin
- 18: Endbereich von 16
- 20: Klemme
- 22: erster Abschnitt
- 24: zweiter Abschnitt
- 26: Kante von 22
- 28: Isolierfolie
- 30: Kerbung
- 32: Vorsprünge
- 34: Gehäuse
- 36: Ausnehmung
- 37: Wandung von 34
- 38: Aussparung
- 40: Stift
- 42: Aussparung, Öffnung

## Patentansprüche

1. Bauteilanordnung, mit
einem elektronischen Bauteil (10) mit wenigstens einem elektrischen Anschlusspin (16);
einer Leiterplatte (12) mit wenigstens einer elektrischen Kontaktfläche (14), mit welcher der Anschlusspin (16) des Bauteils (10) in elektrisch leitendem Kontakt steht; und
einer Befestigungsvorrichtung zum Sichern des elektrisch leitenden Kontakts zwischen dem Anschlüsspin (16) und der Kontaktfläche (14),
**dadurch gekennzeichnet,**
**dass** der Anschlusspin (16) in seinem Endbereich (18) im Wesentlichen parallel zur Leiterplatte (12) verlaufend ausgebildet ist;
**dass** die Kontaktfläche (14) im Randbereich der Leiterplatte (12) angeordnet ist; und
**dass** die Befestigungsvorrichtung eine auf den Rand der Leiterplatte (12) aufschiebbare Klemme (20) aufweist, die einen ersten Abschnitt (22) auf der der Kontaktfläche (14) abgewandten Seite der Leiterplatte (12) und einen zweiten Abschnitt (24) auf der der Kontaktfläche (14) zugewandten Seite der Leiterplatte aufweist, welche die Leiterplatte (12), die Kontaktfläche (14) und den Endbereich (18) des Anschlusspins (16) so zwischen sich aufnehmen, dass der Endbereich (18) des Anschlusspins (16) gegen die Kontaktfläche (14) der Leiterplatte (12) gedrückt wird.

2. Bauteilanordnung nach Anspruch 1,
**dadurch gekennzeichnet,**
**dass** die Befestigungsvorrichtung elektrisch isolierend ausgebildet ist.

3. Bauteilanordnung nach Anspruch 2,
**dadurch gekennzeichnet,**
**dass** die Klemme (20) elektrisch isolierend ausgebildet ist.

4. Bauteilanordnung nach Anspruch 2,
**dadurch gekennzeichnet,**
**dass** zwischen der Klemme (20) und den Komponenten Leiterplatte (12), Kontaktfläche (14) und Anschlusspin (16) eine Isolierfolie (28) angeordnet ist.

5. Bauteilanordnung nach einem der Ansprüche 1 bis 4,
**dadurch gekennzeichnet,**
**dass** die Klemme (20) aus einem federelastischen Material gefertigt ist.

6. Bauteilanordnung nach einem der Ansprüche 1 bis 5,
**dadurch gekennzeichnet,**
**dass** die Klemme (20) am Ende ihres zweiten Abschnitts (24) eine nach innen und zurück gebogene Kante (26) aufweist, die den Endbereich (18) des Anschlusspins (16) gegen die Kontaktfläche (14) der Leiterplatte (12) drückt.

7. Bauteilanordnung nach einem der Ansprüche 1 bis 6,
**dadurch gekennzeichnet,**
**dass** der zweite Abschnitt (24) der Klemme (20) auf seiner dem Endbereich (18) des Anschlusspins (16) zugewandten Seite mit wenigstens einer Kerbung (30) versehen ist.

8. Bauteilanordnung nach einem der Ansprüche 1 bis 7,
**dadurch gekennzeichnet,**
**dass** der Endbereich (18) des Anschlusspins (16) auf seiner der Kontaktfläche (14) zugewandten Seite mit mehreren Vorsprüngen (32) versehen ist.

9. Bauteilanordnung nach einem der Ansprüche 1 bis 8,
**dadurch gekennzeichnet,**
**dass** das Bauteil (10) eine Anzahl von Anschlusspins (16) aufweist;
**dass** die Leiterplatte (12) eine entsprechende Anzahl von Kontaktflächen (14) aufweist; und
**dass** die Befestigungsvorrichtung eine entsprechende Anzahl von Klemmen (20) aufweist, die integral miteinander verbunden sind.

10. Bauteilanordnung nach Anspruch 9,
**dadurch gekennzeichnet,**
**dass** die mehreren Klemmen (20) der Befestigungsvorrichtung einen gemeinsamen ersten Abschnitt (22) und eine entsprechende Anzahl von zweiten Abschnitten (24) aufweisen.

11. Bauteilanordnung nach einem der Ansprüche 1 bis 10,
**dadurch gekennzeichnet,**
**dass** die Befestigungsvorrichtung ferner ein Gehäuse (34) aus einem isolierenden Material aufweist, in dem die Klemme (20) gehalten ist bzw. die mehreren Klemmen (20) gehalten sind; und
**dass** das Gehäuse (34) in der Art eines Randsteckverbinders auf den Rand der Leiterplatte (12) aufschiebbar ist.

12. Bauteilanordnung nach Anspruch 11,
**dadurch gekennzeichnet,**
**dass** das Gehäuse (34) eine Ausnehmung (35) für die Klemme (20) bzw. mehrere Ausnehmungen (35) für mehrere Klemmen (20) enthält.

13. Bauteilanordnung nach Anspruch 11 oder 12,
**dadurch gekennzeichnet,**
**dass** die Leiterplatte (12) mit einer Aussparung (38) zum Aufnehmen einer Wandung (37) des Gehäuses (34) der Befestigungsvorrichtung versehen ist.

14. Bauteilanordnung nach einem der Ansprüche 1 bis 13,
**dadurch gekennzeichnet,**
**dass** das Bauteil (10) auf seiner der Leiterplatte (12) zugewandten Seite wenigstens einen Stift (40) aufweist, dessen Ende in einer Aussparung oder Öffnung (42) in der Leiterplatte (12) geführt ist.

15. Bauteilanordnung nach einem der Ansprüche 1 bis 14,
**dadurch gekennzeichnet,**
**dass** das elektronische Bauteil (10) ein Display ist.

16. Bauteilanordnung nach Anspruch 15,
**dadurch gekennzeichnet,**
**dass** die Bauteilanordnung Teil einer Hausgerätesteuerung oder Hausgeräteregeleinrichtung ist.
